# EUROPEAN PATENT SPECIFICATION

(11) **EP 2 951 868 B1**
(45) Date of publication and mention of the grant of the patent: **13.12.2023**
(21) Application number: 14709424.7
(22) Date of filing: 29.01.2014
(51) Int. Cl.: H01L 31/02, H02S 40/32, H02M 3/07, H02J 3/38

(54) **VOLTAIC SYSTEM AND INTELLIGENT CELL CURRENT CONVERTER TECHNOLOGY**
(FOTO)VOLTAIKSYSTEM UND IC3-TECHNOLOGIE
SYSTÈME (PHOTO)VOLTAÏQUE ET TECHNOLOGIE DE CONVERTISSEUR DE COURANT CELLULAIRE INTELLIGENT (IC3)

(30) Priority: 29.01.2013 NL 2010197
(43) Date of publication of application: 09.12.2015
(73) Proprietor: Roeca B.V., 7534 JB Enschede (NL)
(72) Inventor: PETERS, Callistus Franciscus Antonius, NL-7534 JB Enschede (NL); KOSTER, Martin, NL-7534 JB Enschede (NL); HUIBERTS, Roeland Cornelis, NL-7534 JB Enschede (NL)
(74) Representative: Patent Business B.V.
(86) International application number: PCT/NL2014/050046
(87) International publication number: WO 2014/120002

(56) References cited:
- EP-A1- 2 200 151
- US-A1- 2012 223 583

## Description

### FIELD OF INVENTION

The present invention is in the field of voltaic systems, specifically photovoltaic systems, building elements comprising said system, and products comprising said systems providing improved electrical energy conversion.

### BACKGROUND OF THE INVENTION

In the field of energy conversion, PV-systems are known. These systems generally use a PN-junction to convert solar energy to electricity.

A disadvantage of such a system is that the conversion per se is not very efficient, typically, for Si-solar cells, limited to some 20%. Even using very advanced PV-cells, such as GaAs cells, the conversion is only about 30%. Inherently these systems are limited in their conversion.

Further these systems are relative expensive to manufacture.

Even further, such systems are typically not integrated into for example buildings. Rather such systems are placed on top of for example buildings, or the like, making these kind of systems visually unattractive.

Systems are typically not optimized in terms of energy production, use of energy, availability of energy, etc., especially in view of consumption patterns of a building. Integration with for instance other household applications is otherwise typically not provided.

Systems typically also need to be installed. Such installation is complex in nature, requires piping and/or cabling, and is expensive. Also, complex mounting systems for PV systems onto buildings result in increased failure rates and increased installation costs.

Integration of systems is typically also in its initial stage. Not many applications are available yet.

So existing PV systems show huge power output losses, and significant quantities of generated power are not usable because of e.g. too low power at low light conditions, due to dirty cells, and shading, effecting the total output of a PV-module. Using a micro inverter or the like does not solve this problem.

In general similar problems exist with voltaic systems.

Various documents recite energy conversion systems. WO2007082168 (A2) recites a device and method for harvesting, generating, storing, and delivering energy to a load, particularly for remote or inaccessible applications. The device preferably comprises one or more energy sources, at least one super-capacitor, at least one rechargeable battery, and a controller. The charging of the energy storage devices and the delivery of power to the load is preferably dynamically varied to maximize efficiency. A low power consumption charge pump circuit is preferably employed to collect power from low power energy sources while also enabling the delivery of higher voltage power to the load. The charging voltage is preferably programmable, enabling one device to be used for a wide range of specific applications. The components used are relatively expensive and do not solve all of the problems mentioned.

EP 2 200 151 A1 recites a photovoltaic system for generating an output voltage which is essentially uninfluenced by varying irradiation, the photovoltaic system comprising at least one photovoltaic unit comprising two photovoltaic sources. The system is characterized amongst others in that the photovoltaic unit comprises two voltage adding arrangements each having a first route comprising a voltage source and a second route constituting a voltage source bypass. Therein only *one* battery is used per current converter, which is considered a voltage source. Such does not relate to a voltage adder. Further the system does not describe a comparator, only a means for comparing output power to an instantaneous need. The system further suffers from typical prior art problems and does not provide the advantages of the present invention.

US 2012/223583 A1 recites switched capacitor multilevel output DC-DC converters that can be used as panel integrated modules in a solar maximum power point tracking system. The system can also include a central input current-controlled ripple port inverter. The system can implement per panel MPPT without inter-panel communication, electrolytic capacitors or per panel magnetics. A Marx converter implementation of the switched capacitor module is studied. Average total efficiencies (tracking conversion) greater than 93% can be achieved for a simulated 510 W, 3 panel, DC-DC system. The DC-DC converters are not applied per individual cell. As a consequence the system can e.g. not compensate for shading of (a part of) the panel.

Thus there still is a need for improved energy conversion system, which system overcomes one or more of the above disadvantages, while at the same time not jeopardizing other favourable aspects of energy conversion.

### SUMMARY OF THE INVENTION

The invention is defined by a voltaic system with the technical features of independent claim 1. Alternative embodiments are defined in the dependent claims.

The present invention relates to a voltaic system, having Intelligent cell current converter (IC³) technology incorporated therein, in an example adapted to be attached to a surface or forming part thereof, comprising one or more voltaic units, one or more IC³ circuits, and a optionally a wireless power transmitter, a building element comprising such a system, as well as a technological object comprising said system, products comprising the voltaic system, IC³ circuits and a voltaic multiplying current converter (VMC²) module comprising said IC³ circuits. In an example the present system is highly symmetrical.

The one or more voltaic units provide electrical power input. Examples thereof are photovoltaic units, each unit comprising one or more solar cells.

The IC³ technology is aimed at optimizing output in terms of electrical energy, by upgrading energy provided by e.g. a PV-system, wherein the upgraded power can be harvested at a higher efficiency, that is with fewer losses.

The IC³ circuits and voltaic multiplying current converter (VMC²) module and converter are aimed at maximizing power output and at harvesting power starting at very low levels. Typically a voltaic system is not optimised in terms of power output en power generation. Such is especially important as many voltaic units operate at sub-optimal conditions, thereby not generating any power or at the most a very low amount. Thereto the IC³ circuit comprises voltage adders with charge siphon devices for collecting charge, operable at very low voltage, current adders, operable at low current. It is noted that such a charge siphon device per se does not relate to a battery or the like. One or more switches or the like are provided, the switches connecting the one or more voltage adders alternately to the voltaic units, as well as providing the option to connect or disconnect components of the voltaic system, components such as voltaic unit, voltage adder, IC3, charge siphon device, and comparator. The switch may be switched once a certain typically pre-set voltage, current, or charge is reached. As such the number of e.g. voltage adders in view of the number of voltaic units may be optimised. The voltage adder adds voltage, the current adder adds current, whereas voltage and current are provided by the voltaic unit. In an example the voltage adder is in electrical contact with the voltaic unit, whereas the current adder is in electrical contact with the voltage adder, thereby being in indirect contact with the voltaic unit. In a further example the voltage adder and current adder are interchanged with respect to the previous configuration. Also a comparator is present, the comparator e.g. comparing output voltage of the voltaic units with a threshold value and optionally controlling power harvesting. The threshold value may be provided by one voltaic unit, e.g. a unit operating under sub-optimal conditions. It is noted that the present comparator is use to optimize yield of electrical energy, by comparing in view of varying electrical input. An electrical accumulator may be provided for storing charge, such as a battery, a capacitor, etc.

Amongst others the present system collects all generated power and converts generated power into usable power. The IC³ circuit makes PV systems insensitive for shading effects, causing detrimental effects in e.g. a series of cells, apart from cells not providing a current due to lack of solar radiation. Furthermore at low light conditions the IC³ circuit electronics converts non-usable power in usable power. By using the IC³ circuit electronics the power generation of a PV systems increases 10-20% in comparison to the conventional PV systems and 5-15% in comparison to PV systems with micro-inverters. In an example charge siphon devices, such as a capacitor, are not fully loaded, but partly. Typically the present charge siphon device is loaded to about 63% of its maximal loading capacity. The IC³ circuit is very efficient > 95%, typical 98% under all conditions. The IC³ circuit electronics can be produced at low cost for economy of scale quantities. The IC³ circuit is very robust since it uses conventional electrical components with a proven stability at extreme climate conditions over time (>20years). As indicated throughout the description the IC³ circuit is applicable to in principle any voltaic system, such as a PV-system.

In an example the present system is an easy to install (Plug and Play) PV mounting system based on Wireless Power Transfer (WiPoT) approach at high conversion efficiencies. Using the WiPoT one end of the transmission module (typically the primary winding) may be located in or attached to the voltaic unit, whereas another end (typically the secondary winding) may be attached to e.g. the power grid. For sake of efficient installation magnets may be provided, such as one at each end, for establishing (electromechanical) connection between a first and second end of the WiPoT. The system can be used as stand-alone system (with e.g. electrical energy storage means) and as (part of) a grid, being connected to buildings, or a micro grid.

By using the present voltaic system, in particular a PV-system, a user thereof becomes less dependent of energy suppliers and its fluctuating energy prices. In fact a (largely) stable pricing is established. It is noted that the return of investment costs due to reduced electricity costs is with current prices already within reasonable reach, and with the present system, especially when building integrated, a profitable business case is being established.

The present system can be placed on a building, e.g. on a roof or a wall thereof, the roof and wall forming a surface, or be part thereof, e.g. a roof tile. Likewise the present system can form part of larger PV-systems. The present system can also form a part of a further product, such as low power devices, e.g. a surface of a mobile phone, and as such be (spatially) integrated to some extent. By largely integrating the present system into e.g. a building it may become more aesthetically attractive. Even further, integration in novel or refurbished buildings can reduce the costs thereof as the present system may have more than one function, e.g. conversion of light into energy and protection of a building against influences of the environment.

The present IC³ circuit is adapted to gather electrons in a relative broad power range, starting at a relatively low power. Thereby e.g. the efficiency, total output (over e.g. a year), threshold, performance in non-optimal weather conditions (cloudy weather) are improved significantly.

The present wireless power transmitter provides for lower costs for the system, as no or less cables are needed, maintenance is reduced, and lower costs of installation, e.g. because a place-and-click system may be used, such as roof and wall systems.

As such the present invention overcomes one or more of the above problems and/or disadvantages.

Various elements of the present apparatus as well as advantages will be discussed below in detail.

In a first aspect the present invention relates to a voltaic system according to claim 1. In a preferred example the present invention relates to a photovoltaic unit. However, in principle the invention is applicable to any e.g. in electrical terms similar, voltaic unit. As such the present invention relates to such voltaic units in general.

The IC³ circuit comprises one or more voltage adders, two or more first charge siphon devices per unit, preferably 2-100 siphon devices per unit, such as 4-50 siphon devices per unit, wherein the one or more first siphon devices are electrically connected in series to one and another. Therewith a voltage is multiplied by a first factor being in the example above from 2-100, assuming the same charge siphon devices are used. It is noted that by switching, e.g. by using more or less charge siphon device, per IC³ circuit a different multiplying factor may be obtained, the factor being from 2-100. In an idle mode the first factor may also be 1.

By introducing a voltage adder a voltage output of a (photo)voltaic unit (source) can be increased. As such e.g. 12 V, 24 V, 240 V and 400 V output can be generated. Likewise a current adder may be introduced, such as when adding the current, such as of at least 2 parallel sources. In both cases such is established preferably using a Maximum Power Point Tracker. Therewith an optimum is created in terms of power output

The IC³ circuit comprises at least two charge siphon devices per unit, such as a capacitor, preferably having a relatively small capacitance of e.g. 1 - 100 nF, such as 2-50 nF. The module preferably operates at a power of less than 1 mW, more preferably less than 0.5 mW, even more preferably less than 0.25 mW, such as at about 0.1 mW. In an example the IC³ circuit has a power usage of less than 400 µW and a shutdown current of 400µA.

Therewith e.g. parasitic power losses are reduced significantly to about 10⁻⁶-10⁻² of the output, depending on operating conditions.

The present invention provides as a consequence a system with a relatively high internal capacitance. Therewith in principle a relatively high storage capacity is provided as well.

Contrary to many prior art systems energy can now be harvested at a PV-cell level. Such provides huge advantages, at minimal extra costs.

In an example of the (photo)voltaic system further comprises a device for wireless transmission of energy, preferably electromagnetic energy, which device comprises a primary and a secondary coil or winding, and optionally a generator/oscillator. Therein the primary winding is electrically coupled to the one or more (photo)voltaic units or is in an idle mode, the secondary winding is coupled to one or more of a load device and power grid, the primary winding is located at a first side of the surface and the secondary winding is located at a second side of the surface. As such electrical energy is transferred from a first side of the surface, e.g. outside a building, to a second side of the surface, e.g. inside a building. As a consequence a reliable means for transfer is provided, having a high efficiency, e.g. of more than 95%, and no need for extra cabling. Examples of the present system have already achieved coupling factors of > 99,98 %.

The one or more (photo)voltaic units, and one or more of IC³ circuit and wireless power transmitter are adapted to be in electrical contact with one and another or to be idle. In other words the unit, module and transmitter may be in an active mode that is in electrical contact, thereby transferring energy, or in idle mode, that is not in electrical contact. Components or parts thereof can be switched "on" and "off". Thereto one or more switches and a comparator are provided in the present system. The comparator e.g. compares voltage and current of a number (or all) of voltaic units, and likewise of first and second series of voltaic units, such as of PV-cell strings, and optimises settings of switches in terms of power output.

In an example the (photo)voltaic system further comprises one or more of various controls, an optimized energy collecting unit operable at very low voltage, as well as an energy transfer unit, using wireless technology, a timer, a collector cell, a display, and a processor.

In an example the PV-unit comprises an optically transparent photovoltaic unit, such as a Dye Solar Cell (DSC), which unit comprises a first contact, a second contact, a chamber, which chamber comprises a first and second component, which first and second component are adapted for converting radiation into direct current electricity, which chamber has at least 20% optical transmittance, preferably at least 30% optical transmittance. An advantage is that some or most light can be transmitted, and the PV-system can then also function as an optical window. In bright light conditions, such as in summer, the PV-system then also functions as a shield; even further the optical characteristics of the PV-system may be varied, e.g. transmittance may vary depending on requirements.

If e.g. a roof tile is used, the PV-unit may follow the shape of the roof tile, i.e. be bend.

In an example the (photo)voltaic unit comprises 1-10 (photo)voltaic cells, preferably 1-5 (photo)voltaic cells, such as 2-4 (photo)voltaic cells. In principle a unit may comprise any number of cells. Preferably 2 or more cells form a unit, e.g. as one module and one transmitter per unit are sufficient. However, preferably not too many cells form a unit, e.g. as efficiency of transmission may drop at higher voltages. The units and cells may be connected in series and/or in parallel. As such large strings of cells and units may be formed. In case of a roof tile e.g. two cells form one unit, such as having an area of 5x10 cm2 per cell, wherein a roof tile comprises 1-4 units.

In an example the IC³ circuit further comprises one or more of a power supply (U5), a controller, a timer, a collector cell, a display, a module for converting a constant current and variable voltage to a variable current and a constant voltage, such as a low drop out (LDO) module, an inverter, and a processor, and/or wherein the (IC³) circuit comprises 2^{m} charge siphon devices, wherein m is selected from {2;10}, preferably from {3;9}, such as {4;8}. The power supply may be provided e.g. in stand-alone application, in order to provide the IC³ circuit with (start-up) power. The power supply may also be used to provide power to further components of the IC³ circuit , such as timer, controller, etc. The controller is aimed at optimizing power output e.g. by switching connections between (individual) voltage adders and voltaic units, by controlling power supply to e.g. a grid, etc. The controller and comparator may be integrated into one component. The processor is aimed at calculating optimal situations under given boundary conditions, comparing boundary conditions, e.g. with a threshold, controlling power harvesting, etc. Also an AD-converter may be provided. Further a module for converting a constant current and variable voltage to a variable current and a constant voltage, such as a low drop out (LDO) module, in view of further use of energy and matching of current and/or voltage. Likewise an inverter may be provided.

In an example the (photo)voltaic system further comprises at least one second electrical accumulator, preferably part of the WiPoT transmitter, such as a Li-ion accumulator and a capacitor. The accumulator can store electrical energy over a period of time, e.g. before releasing it on demand. The accumulator can be a state of the art product. Preferably the accumulator is optimised e.g. in terms of applied voltage, current, output, loading, capacity, costs, charging time, etc.

In an example of the (photo)voltaic system the harvesting module comprises one or more transistors, preferably one or more FETs, wherein the one or more transistors operate at maximum power point, e.g. having a limited operating voltage range, such as from 0.75-1.25 V, preferably from 0.9-1.1 V, such as from 0.95-1.05 V. In an alternative an operating voltage range is chosen to be 0.25-0.75 V, preferably from 0.4-0.6 V, such as 0.5V. In the claims said voltage (or voltage range) is also referred to as first voltage. For instance a MOSFET, a JFET, and the like may be used. An advantage thereof is that it can operate at much lower current and/or voltage, thereby reducing e.g. energy losses.

In an example of the (photo)voltaic system comprises at least one voltaic multiplying current converter (VMC²) module per voltaic unit, each module comprising at least two IC³ circuits in series.

In an example of the (photo)voltaic system provides a) a variable voltage and a constant current having at least two voltaic units in series or for provides (b) a variable current and a constant voltage having at least two voltaic units in parallel, or combinations thereof. Therewith a degree of flexibility is introduced, which flexibility can be used in view of output requirements.

In an example of the (photo)voltaic system the controller is adapted to sample the one or more (photo)voltaic units, preferably at a predetermined first frequency, more preferably at a first frequency of 100-100.000 Hz, such as 500 - 50.000 Hz, preferably at 1-3 kHz, depending on system characteristics. By sampling an actual status of a cell or unit can be obtained, thereby providing e.g. further optimisation options. Preferably the sampling is performed at a relatively high frequency, providing an actual status e.g. more than once per second.

In an example the controller connects the one or more (photo)voltaic units to one of the one or more first charge siphon devices, preferably at a predetermined second frequency, preferably at a modulated second frequency, preferably a sinusoidal frequency of more than 25 kHz. In an example more than 100 kHz is used. Thereby electrical energy is transferred to the siphon devices before reaching a maximum capacity. Even further the siphon devices can as a consequence be relatively small.

In an example the controller comprises a maximum power point tracker. Therewith energy transfer can be optimised. As input for the maximum power point tracker voltage and electrical current can be taken. Also light intensity may be used in this respect. Typically a calibration curve of light intensity versus voltage, electrical current and power can be obtained or can be made available. Based on light intensity and/or voltage or the like energy harvesting can start or end. Sampling at a variable or constant frequency of relevant parameters may assist the maximum power point tracker, and likewise a controller.

In an example of the (photo)voltaic system the controller comprises a switching device, and/or wherein the controller comprises an optimiser. Therewith e.g. output can be optimised. In principle at least one switch per PV-unit is provided. However, one switch may also be in connection with more than one PV-unit, such as a multiplexer. In principle as many switches are provided as deemed necessary in order to provide flexibility, e.g. under various (weather) conditions, maximum power, constant voltage or constant current, etc.

In an example of the (photo)voltaic system a capacitance of the (photo)voltaic unit is 0-50% smaller than a capacitance of one of the one or more voltage adders, and/or wherein the one or more charge siphon devices comprise one or more accumulators, such as capacitors, wherein preferably the one or more electrical accumulators have a capacitance of more than 10 times the capacitance of the one or more voltage adders, preferably of more than 100 times, more preferably of more than 500 times, even more preferably of more than 1000 times, and/or wherein the one or more electrical accumulators operate in an operating voltage range of 1-10 V.

In an example of the (photo)voltaic system further comprises a means for storage of energy.

In an example the chamber of the photovoltaic system relates to a substantially closed container, having a certain volume. A typical height of the chamber is from 0.5 - 2.0 mm, preferably about 1 mm. The chamber is provided at a top side and bottom side thereof with a transparent closure, such as a glass plate, a polycarbonate plate, or the like. A typical thickness of a closure is from 1 mm - 3 mm each. The closure provides strength to the chamber and system. The closure is in an example more than 90 % transmittance (to light), such as Planibel Clear (3 mm) of AGC Europe. Other characteristics of such a closure material are considered relevant as well.

In an example a number of systems is contacted in series and/or parallel. Typical numbers are from 1-1000, such as 2-500, such as 10-250, e.g. 72, 100 and 144.

The present chamber comprises a first and second component. Typically a first component is a solid and a second component is a liquid. An example of a solid is TiO₂. An example of a liquid is a solution comprising a dye. As such the present system provides a huge range of colours, as dyes may be mixed into a required and/or desired colour. Such is very attractive for e.g. buildings.

The number of systems may be provided with different colours per system, or varying colours. As such patterns may be formed, such as a rainbow, a logo of a firm, a mosaic like painting etc. Therefore the present system allows for variation in appearance and in principal any 2-dimensional figure may be formed.

The present system and product also provide for many different designs, e.g. in terms of 3-D structure. Therein also further elements may be provided, such as internal or external reflective coatings, such as a mirror. Also a one-sided mirror may be provided, being transparent from one side, e.g. an inner side, and reflective on another side.

Due to presence of the second component and possibly also the first component the chamber has at least 20% optical transmittance, preferably at least 30% optical transmittance. It is preferred to have some light transmitted through the system, as the system typically also functions as a building element. As such the system may also function as a screen, not allowing (sun) light to pass through. Such integration of functions clearly limits total costs involved, e.g. of decorating a building.

Typical dimension of a contact in a DSC are a width of 0.1-2 mm, such as 0.5-1 mm, a thickness of 5 - 1000 µm, such as 25 - 500 µm, such as 50 - 250 µm. Typically at least one contact meanders through the chamber, in order to minimize a distance between a location where electrons are formed (in the liquid) and contact.

In an example of the DSC the first and/or second contact form an elongated structure. Therewith output is further increased.

In an example the DSC further comprises means for refracting light, which means direct light away from the first and/or second contact towards the first and second component. Therewith the amount of PV-material relative to e.g. a surface area of the DSC can be minimised, thereby minimising costs and meanwhile maintaining output.

The photovoltaic unit may also be a monocrystalline or polycrystalline silicon unit or the like. In an example the one or more photovoltaic units are selected from single junction and multi junction semiconductor PV-units, such as Si-units, III-IV -units, thin film solar units, such as CdTe, CuInGaSe, GaAs, organic units, polymer units, dye solar units, back contact systems, and combinations thereof. In an example a back contact system and the present cell current converter are combined. The present invention provides possibilities to optimise the present photovoltaic unit e.g. in terms of appearance, output, functionality, etc.

Also combinations of the above features for voltaic cells are envisaged.

In a second aspect the present invention relates to a product, such as building integrated photo voltaic (BIPV) element, a building applied photo voltaic (BAPV) element, an off-grid system, a solar farm, a Voltaic element, electrical accumulator, chip, mobile phone, device, roof-tile, appliance, game, trademark, brand name, timer, remote control, picture, logo, graphics, stand-alone system, and combinations thereof, comprising a Voltaic system according to the invention.

For a building integrated element the present product may also function as or include means for thermal and/or sound insulation. Even further, the present product may be used to create a space between e.g. an inner wall and the product, the space functioning as insulation. The space may be filled with insulation material as well. The present product may be in any required form, such as substantially flat, undulated, curved, and combinations thereof.

Within the present system or product PV-cells- and units may be placed in series, in parallel, and combinations thereof.

The present system and product provide for decen-tralised generation and storage of energy, e.g. in a neighbourhood. Such is particularly efficient in terms of energy losses, e.g. as when using a power grid energy losses for transport are quite significant.

The present system and product are e.g. provided in standard sizes. When applying the present system and or product when redecorating or building new homes an energy supply is provided at relatively low extra costs. As a consequence the present invention is applicable in any situation were voltaic energy can be harvested from e.g. sunlight, i.e. also at sub-optimal locations in terms of amount of sunlight received, such as partly in the shadow, on north and east side of a building (northern hemisphere) etc.

In an example the product comprises a means for storage of energy, and/or comprising two or more wireless power transmitters, preferably connected parallel, and/or comprising one or more Intelligent cell current converters (IC³) circuits and/or one or more voltaic multiplying current converter (VMC²) modules.

In an example the product or building element further comprises domotica. Therewith demand and supply can be optimised, e.g. in terms of amount stored, capacity of components, etc.

In an example the present product is adapted to be used in series and/or in parallel, such as a roof-tile, a PV-unit, and in a grid.

In an example the present product has a random size, and/or wherein the product has a regular shaped size, such as rectangular, circular, multigonal, such as hexagonal, and octagonal, and/or wherein the product is curved. A random size allows production and application of the present product at any (given) location. The present product may also follow a curvature of a given location, such as a roof tile.

The present invention relates also to a technological object comprising a (photo)voltaic system according to the invention.

In a third aspect the present invention relates to a use of the present (photo)voltaic system or a present product for improving output of a (photo)voltaic system.

In further aspects the present invention relates to an Intelligent cell current converter (IC³) circuit and to a voltaic multiplying current converter (VMC²) modules, which circuits and module have a multitude of electrical applications.

The invention is further detailed by the accompanying figures, which are exemplary and explanatory of nature and are not limiting the scope of the invention.

### SUMMARY OF THE FIGURES

Fig. 1a-g show schematical lay-outs of a VMC² module and IC3 technology.
Fig. 2 shows a schematical lay-out of a VMC² module and a WiPoT.
Fig. 3 shows a present configuration.
Fig. 4 shows an example of the present WiPoT.

### DETAILED DESCRIPTION OF THE INVENTION

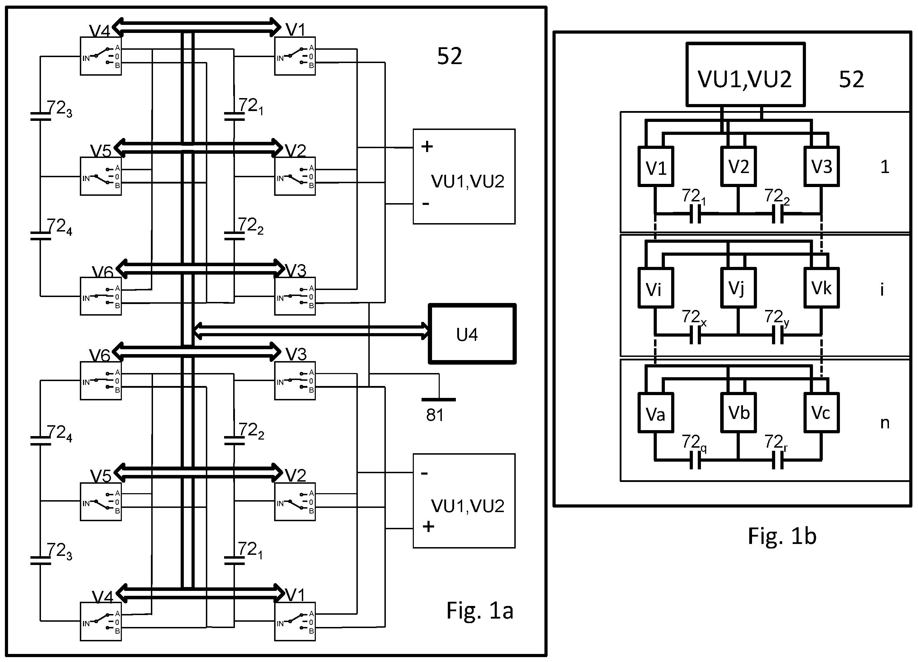

In figure 1a two PV-cells are provided forming one PV-unit (VU1, VU2). The PV-unit is connected to a first series of switches (V1,V2,V3). The switch may be in one of three positions, indicated with A, 0 (neutral) and B. By alternating setting of these switches capacitors (72₁, 72₂) are loaded. In figure 1a further a controller U4 is provided. Communication with switches (V1,V2,V3) can be provided by a bus or the like. Communication can be wireless, by electrical current and by magnetic field, and a combination thereof. In the example two capacitors are shown. In principle two or more capacitors may be used, such as 3-10 in series. It is preferred to use 2 capacitors, in view of optimal yield. The present system increases power and reduces current, therewith reducing losses during transport. The present system uses preferably Maximum PowerPoint Tracking, preferably at a chosen voltage of e.g. 0.5V. Preferably the VMC² is provided in a chip. As such one chip per PV-cell may be provided. The chips may be interconnected, either in series, preferably in parallel. An advantage of the present invention is that if one PV-cell does not provide output or a significantly reduced output, the system as a whole provides almost the same output as before, contrary to prior art systems.

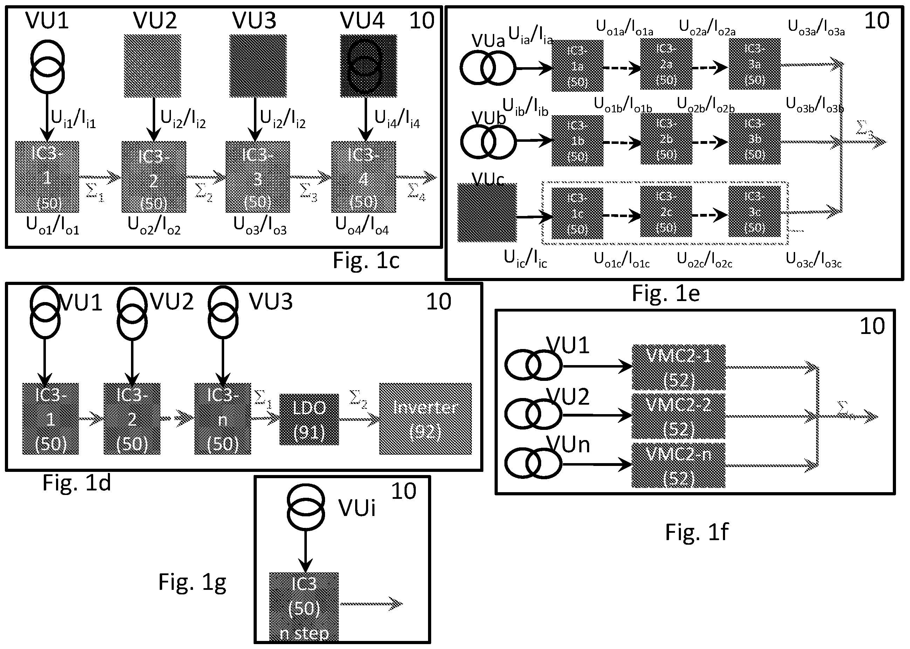

In figure 1b a VMC² module (50) comprises a series of 1,..i,..n switches (V1,V2,V3;Vi,Vj,Vk;Va,Vb,Vc) and capacitors (72₁, 72₂; 72ₓ, 72_{y}; 72_{q}, 72ᵣ). The example shows only three (1,i,n) out of n switches and capacitors. In figure 1c four voltaic units (VU1-VU4) are shown connected in series. The three units on the right are not functioning fully, e.g. due to shading. As a consequence the output is in the example limited to about 50% to 4A (second unit), 75% to 2A (third unit), and 12,5% to 1A (fourth unit) (compared to 8A for the unit on the left). All units operate in the example at about 0,5 V. By providing IC3 (50) technology to each voltaic unit the current is kept constant (to 1A in the example), whereas the voltage is added, from 4V towards 6V, 7V and 7,5V on the right, respectively. The most right unit is considered limiting, e.g. providing only 1A. The IC³-4 provides a (1 step) multiplication/division of 1 (equal). The output voltage Uₒ₄=Uᵢ₄x1 (0,5V) and the output current is Iₒ₄=Iᵢ₄/1 (1A). As a consequence the IC³-3 provides a (2 step) multiplication/division of 2. The output voltage Uₒ₃=Uᵢ₃x2 (1, 0V) and the output current is Iₒ₃=Iᵢ₃/2 (1A) . As a consequence the IC³-2 provides a (4 step) multiplication/division of 4. The output voltage Uₒ₂=Uᵢ₂x4 (2,0V) and the output current is Iₒ₂=Iᵢ₂/4 (1A). As a consequence the IC³-1 provides a (8 step) multiplication/division of 8. The output voltage Uₒ₁=Uᵢ₁x8 (4,0V) and the output current is Iₒ₁=Iᵢ₁/8 (1A). The summed voltages Σᵢ are from left to right 4,0V, 6,0V, 7,0V and 7,5V, respectively, at a constant current of 1A. Therewith the system as a whole is electrically balanced. Herein power is collected per cell and bundled in series.
In figure 1d the present n voltaic units having each one IC3 circuit further comprise a module for converting a constant current and variable voltage Σ₁ to a variable current and a constant voltage Σ₂, such as a low drop out (LDO) module (91), and an inverter (92).

In figure 1e three voltaic units (VU) are connected in parallel. One (the lower) voltaic unit is partly shaded, and as a consequence providing less current (Iᵢⱼ; 4A compared to 8A for the top two), all at 0,5V (Uᵢⱼ). Each voltaic unit has a series of IC^{3,}s, (50) in the example 3. The IC³1a,b,c multiply the voltage by a factor 4 and divide the current by a factor 4, providing an output Uₒ₁ₐ=Uᵢ₁ₐx4 (same for b,c), and a output Iₒ₁ₐ=Iᵢ₁ₐ/4 (same for b,c), whereas for IC³2a,b,c and IC³3a,b,c the factor is 2, providing an output Uₒ₂ₐ=Uᵢ₂ₐx2 (same for b, c), and a output Iₒ₂ₐ=Iᵢ₂ₐ/2 (same for b, c) (an same for IC³3a, b, c). The final output is 8V and 1,25 A (Σ₃). It is noted that in principle any factor may be chosen, the factor typically being an integer, such as 2, 3, 4, 5, 6, 8 etc. Typically a factor 2ⁿ is chosen, n typically being ∈[1,10]. It is preferred to optimise a maximal power output. In a preferred example the factor is 2. Herein power is collected per cell and bundled in parallel. As a result a constant voltage and a variable output are provided.

In figure 1f figure 1e is presented somewhat different. Therein each VMC² (52) comprises in the example 3 IC³'s. The number of IC³'s per VMC² may vary from a minimum of 1 to about 10, such as 2-8, preferably 3 or 4.
As such the present options of connecting cells in series or in parallel provide a possibility of generating constant current or constant voltage and collecting power fully. Of course combinations of parallel and series are envisaged. As a consequence not fully functioning voltaic units do not hinder power harvesting; in fact all or almost all energy is harvested. Even further also at very low power output energy is harvested, contrary to prior art systems.

In figure 1g a principle of the present IC3 circuit is presented. Therein current is divided and voltage is multiplied in n steps. As a consequence Uₒ₁=Uᵢ₁xn and Iₒ₁=Iᵢ₁/n, the multiplication/division factor being n. For instance n may be 2, the factor as a consequence being 2, etc.

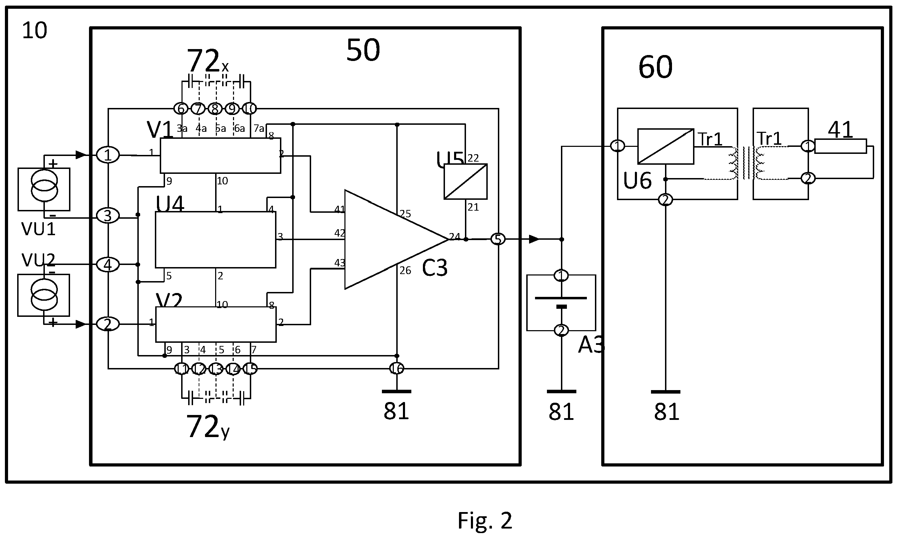

In figure 2 two PV-cells are provided forming one PV-unit (VU1, VU2). A current in maximum power point for VU1 is Iₘₚₚ₁=Uₘₚₚ₁/Rₓ, and for VU2 is Iₘₚₚ₂=Uₘₚₚ₂/Rₓ. The cells are connected to an optional voltaic multiplying current converter module (50). A voltage adder (V1, V2) connects the PV-cell to two or more harvesting capacitors (72), or is switched off (open). The output current of the voltage adder U1 is Iₒᵤₜ₁=n x Uₘₚₚ₁/Rₓ, for U2 is Iₒᵤₜ₂=n x Uₘₚₚ₂/R_{y}, wherein n is the number of capacitances, taking all capacitances are equal. Also a microcontroller (U4) is provided, typically comprising a processor. Switching and harvesting can be optimised by using a modulated frequency. As such every cell can be treated as a unique cell, having specific characteristics. When switching preferably also the ground is switched at the same time. The capacitance of the harvesting capacitor is preferably about 10% smaller than the capacitance of the PV-cell. When switching the capacitance of a PV-cell is connected to the capacitance of one of the harvesting capacitors, and typically then switched to another harvesting capacitance. Further a current adder (C3), providing a current Iₒᵤₜ₁ + Iₒᵤₜ₂, connects the voltage adders to a wireless power transmitter (60). Optionally a Li-ion accumulator (A3) is provided, e.g. a 3.7 V 650 mA battery, as well as a VMC2-power supply (U5). A current of I_{chrg}= U_{accu}/R_{z} is provided to the WiPoT. The wireless power transmitter comprises a primary (Tr1) and a secondary (Tr2) winding. Optionally a WiPoT generator (U6) is provided. Further the secondary winding is connected to a load resistance (41), or to the power grid, or to a further accumulator, such as a battery pack, e.g. having a 3-5 kW storage capacity. Optionally the WiPoT is idle.

In an example a coil is used with an inductance of < 4000 nH, preferably 400-600 nH. In an example a gap in the transformer is smaller than 250 µm, preferably smaller than 50 µm, such as smaller than 10 µm. As such magnetic field lines have been found to be trapped inside the transformer.

The PV-unit may be connected to domotica, e.g. a computer. Power storage, consumption, usage pattern, etc. can thereby be optimised with respect to one and another.

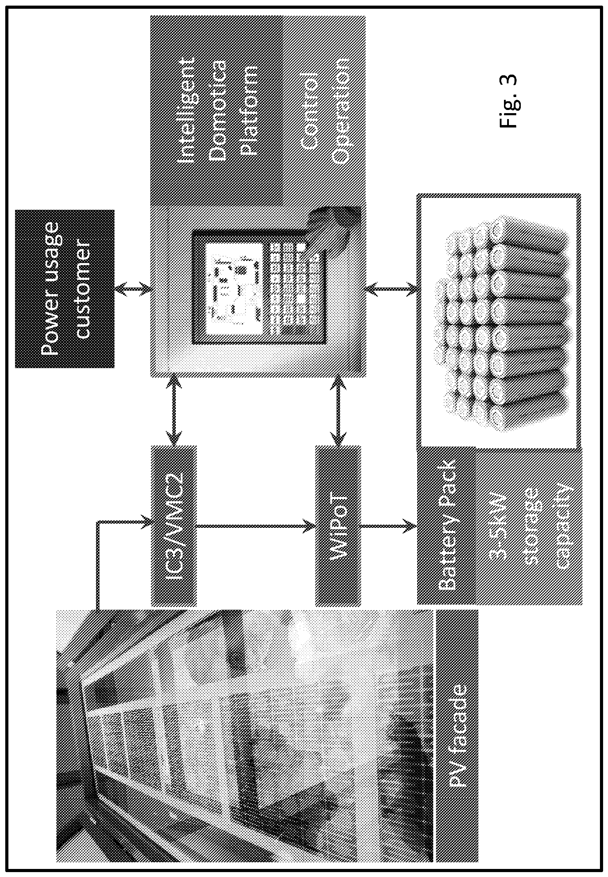

In figure 3 a schematic representation of a present system including a VMC², a WiPot, Domotica, PV-units, a storage, and electrical grid is shown.

In an example the present systems have an electrical conversion efficiency of 97% or more in an operating range of 0.001-4W. In an example a voltage of 0.5 V, quite typical for a PV-system, is converted to 2 V. A sampling frequency may be fixed, and may be regulated automatically.

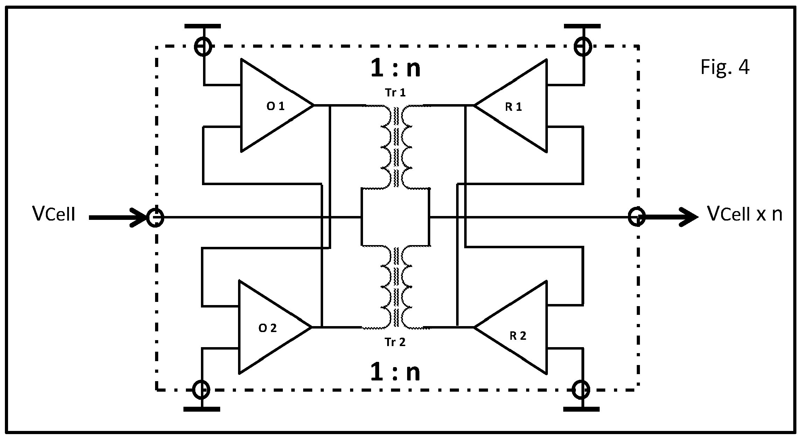

Fig. 4 shows an example of the present WiPoT. The circuit is a power oscillator (primary side of transformers) which convert a low (DC) direct voltage with a high current to a high (AC) alternating voltage and low current. Directly thereafter it is converted (rectified) to a high (DC) direct voltage at a secondary side of the transformers. IN Fig. 4 at a left side a voltage V_{cell} is provided, such as by a solar cell. Two oscillators, 01 and 02, such as voltage controlled oscillators, are used to control the two transformer Tr1 and Tr2. In an example a first transformer, e.g. Tr1, may be used to transform a positive part of the sinusoidal signal, whereas a second transformer, e.g. Tr2, may be used to transform a negative part of the sinusoidal signal. The transformers have a multiplication factor of n, such as 2, 4, 8 etc. Two rectifiers, R1 and R2, are used to provide a direct current. As a result an output potential of n times the cell potential is provided.

## Claims

1. Voltaic system (10) for optimizing output in terms of electrical energy, the voltaic system comprising
at least two voltaic units (VU1, VU2), the voltaic units being electrically coupled to one and another, wherein each voltaic unit is capable of operating at one voltage and at one or more currents,
at least one Intelligent cell current converter circuit, IC³, (50) for multiplying the voltage of the at least two voltaic units by a first factor and dividing the one or more currents of the at least two voltaic units by the first factor, and
one or more of (a) a wireless power transmitter, WiPoT, for wirelessly transmitting the power output by the IC³ circuit and (b) an electrical accumulator (A3) for storing charge from the power output by the IC³ circuit (50),
the at least one IC³ circuit (50) comprising:
(i) two or more (n) voltage adders (V1, V2) and one or more current adders (C3), the output of the two or more voltage adders being connected to the input of the one or more current adders,
(ii) two or more charge siphon devices (72) per voltage adder, preferably 2-100 siphon devices per voltage adder, such as 4-50 siphon devices per voltage adder, wherein the two or more charge siphon devices are electrically connected in series to one and another, wherein the two or more charge siphon devices are adapted to be in electrical connection with the one or more voltage adders, and wherein the two or more charge siphon devices comprise one or more capacitors,
(iii) one or more switches for electrically connecting or disconnecting components of the voltaic system, the components being selected from the at least two voltaic units, the at least one IC³ circuit, the WiPOT, the electrical accumulator (A3), the two or more voltage adders, and the two or more charge siphon devices, and
(iv) a comparator (U4) for comparing the output voltage of the voltaic units with a threshold value and optionally controlling power harvesting,
the wireless power transmitter (60) comprising
a primary winding (Tr1), a secondary winding (Tr2), and a generator or oscillator (U6),
wherein the primary winding is adapted to be electrically coupled to the one or more IC³ circuits via the generator or oscillator (U6), and
wherein the secondary winding is adapted to be electrically coupled to one or more of a load device and power grid.

2. Voltaic system according to claim 1, adapted to be attached to a surface or forming part thereof, wherein the voltaic unit is a photovoltaic unit, each unit independently comprising 1-10 photovoltaic cells, preferably 1-5 photovoltaic cells, such as 2-4 photovoltaic cells.

3. Voltaic system according to at least one of the preceding claims, wherein the at least one IC³ circuit comprises 2^{m} charge siphon devices, wherein m is selected from {2;10}, preferably from {3;9}, such as {4;8}.

4. Voltaic system according to at least one of the preceding claims, wherein, when the voltaic system comprises one or more of a WiPOT, the WiPoT transmitter further comprises at least one second electrical accumulator (41), such as a Li-ion accumulator and a capacitor.

5. Voltaic system according to at least one of the preceding claims, wherein the at least one IC³ circuit comprises one or more transistors, preferably one or more FETs, wherein the one or more transistors have an limited operating voltage range, such as from 0.75-1.25 V, preferably from 0.9-1.1 V, such as from 0.95-1.05 V, or from 0.25-0.75 V, preferably from 0.4-0.6 V, such as 0.5V.

6. Voltaic system according to at least one of the preceding claims, wherein, when the voltaic system comprises more than one IC³ circuit (50), it comprises at least one voltaic multiplying current converter, VMC², module (52) per voltaic unit, each module comprising at least two IC³ circuits in series.

7. Voltaic system according to at least one of the preceding claims, for providing (a) a variable voltage and a constant current having at least two voltaic units in series or for providing (b) a variable current and a constant voltage having at least two voltaic units in parallel, or combinations thereof.

8. Voltaic system according to at least one of claims 3-7, further comprising a controller for optimizing power output by switching connections between voltage adders and voltaic units, and by controlling power supply, wherein the controller is adapted to sample the one or more voltaic units, preferably at a predetermined first frequency, more preferably at a first frequency of 100-100.000 Hz, such as 500 - 50.000 Hz, preferably from 1-3 kHz, and/or wherein the controller connects the one or more voltaic units to one of the one or more charge siphon devices, preferably at a predetermined second frequency, preferably at a modulated second frequency, preferably a sinusoidal frequency of more than 25 kHz, and/or
wherein the controller comprises a maximum power point tracker, MPPT, and/or
wherein the controller comprises a switching device, and/or wherein the controller comprises an optimiser.

9. Voltaic system according to at least one of the preceding claims, wherein the one or more voltaic units are selected from single junction and multi junction semiconductor PV-units, such as Si-units, III-IV -units, thin film solar units, such as CdTe, CuInGaSe, GaAs, organic units, polymer units, dye solar units, back contact systems, and combinations thereof, and/or
wherein a capacitance of a voltaic unit is 0-50% smaller than a capacitance of one of the one or more voltage adders, wherein preferably the one or more electrical accumulators have a capacitance of more than 10 times the capacitance of the one or more voltage adders, preferably of more than 100 times, more preferably of more than 500 times, even more preferably of more than 1000 times, and/or wherein the one or more electrical accumulators operate in an operating voltage range of 1-10 V.

10. Product, selected from a building integrated photo voltaic, BIPV, element, a building applied photo voltaic, BAPV, element, an off-grid system, a solar farm, a voltaic element, electrical accumulator, chip, mobile phone, device, roof-tile, appliance, game, timer, remote control, stand-alone system, and combinations thereof, comprising a Voltaic system according to any of claims 1-9

11. Product according to claim 10, wherein the product is adapted to be used electrically in series and/or in parallel, such as a roof-tile, a PV-unit, and in a grid, and/or wherein the product has a random size, and/or wherein the product has a regular shaped size, such as rectangular, circular, multigonal, such as hexagonal, and octagonal, and/or wherein the product is curved.

12. Building comprising one or more voltaic systems according to any of claims 1-9 or one or more products according to claim 11.

## Patentansprüche

1. Voltaisches System (10) zur Optimierung der Leistung in Form von elektrischer Energie, wobei das voltaische System umfasst
mindestens zwei Voltareinheiten (VU1, VU2), die elektrisch miteinander gekoppelt sind, wobei jede Voltareinheit mit einer ersten Spannung und einem oder mehreren Strömen arbeiten kann,
mindestens eine intelligente Zellenstromwandlerschaltung (IC3) (50) zum Multiplizieren der Spannung der mindestens zwei voltaischen Einheiten mit einem ersten Faktor und zum Teilen des einen oder der mehreren Ströme der mindestens zwei voltaischen Einheiten durch den ersten Faktor, und
einem oder mehreren von (a) einem drahtlosen Energiesender (WiPoT) (60) zum drahtlosen Übertragen der von der IC3-Schaltung ausgegebenen Energie und (b) einem elektrischen Akkumulator (A3) zum Speichern von Ladung aus der von der IC3-Schaltung (50) ausgegebenen Energie,
wobei der mindestens eine Stromwandler IC3 (50) der intelligenten Zelle folgende Schaltungen umfasst
(i) zwei oder mehr (n) Spannungsaddierer (V1, V2) und einen oder mehrere Stromaddierer (C3), wobei der Ausgang der zwei oder mehr Spannungsaddierer mit dem Eingang des einen oder der mehreren Stromaddierer verbunden ist
(ii) zwei oder mehr Ladungssiphonvorrichtungen (72) pro Spannungsaddierer, vorzugsweise 2-100 Siphonvorrichtungen pro Spannungsaddierer, wie z.B. 4-50 Siphonvorrichtungen pro Spannungsaddierer, wobei die zwei oder mehr Ladungssiphonvorrichtungen elektrisch in Reihe miteinander verbunden sind, wobei die zwei oder mehr Ladungssiphonvorrichtungen angepasst sind, um in elektrischer Verbindung mit dem einen oder den mehreren Spannungsaddierern zu stehen, und wobei die zwei oder mehr Ladungssiphonvorrichtungen einen oder mehrere Kondensatoren umfassen,
(iii) einen oder mehrere Schalter zum elektrischen Verbinden oder Trennen von Komponenten des voltaischen Systems, wobei die Komponenten aus den mindestens zwei voltaischen Einheiten, der mindestens einen IC3-Schaltung, dem WiPOT, dem elektrischen Wechselstromsammler (A3), den zwei oder mehreren Spannungsaddierern und den zwei oder mehreren Ladungsabsaugvorrichtungen ausgewählt sind, und
(iv) einen Komparator (U4) zum Vergleichen der Ausgangsspannung der galvanischen Einheiten mit einem Schwellenwert und zum optionalen Steuern der Energiegewinnung,
wobei der drahtlose Energiesender (60) umfasst
eine Primärwicklung (Tr1), eine Sekundärwicklung (Tr2), und einen Generator oder Oszillator (U6),
wobei die Primärwicklung so ausgelegt ist, dass sie über den Generator oder Oszillator (U6) elektrisch mit dem einen oder den mehreren IC3-Schaltkreisen gekoppelt werden kann, und
wobei die Sekundärwicklung so ausgelegt ist, dass sie elektrisch mit einer oder mehreren von einer Lastvorrichtung und einem Stromnetz gekoppelt ist.

2. Voltaisches System nach Anspruch 1, das zur Anbringung an einer Oberfläche oder einem Teil davon geeignet ist, wobei die voltaische Einheit eine photovoltaische Einheit ist, wobei jede Einheit unabhängig 1-10 photovoltaische Zellen, vorzugsweise 1-5 photovoltaische Zellen, wie z.B. 2-4 photovoltaische Zellen umfasst.

3. Voltaisches System nach mindestens einem der vorangehenden Ansprüche, wobei die (IC3)-Schaltung 2m Ladungssiphonvorrichtungen umfasst, wobei m ausgewählt ist aus {2;10}, vorzugsweise aus {3;9}, wie {4;8}.

4. Voltaisches System nach mindestens einem der vorangehenden Ansprüche, wobei, wenn das voltaische System einen oder mehrere von (i) einem WiPOT umfasst, der WiPoT-Sender ferner mindestens einen zweiten elektrischen Akkumulator (41), wie einen Li-Ionen-Akkumulator und einen Kondensator, umfasst.

5. Voltaisches System nach mindestens einem der vorhergehenden Ansprüche, wobei die (IC3)-Schaltung einen oder mehrere Transistoren, vorzugsweise einen oder mehrere FETs, umfasst, wobei der eine oder die mehreren Transistoren einen begrenzten Betriebsspannungsbereich haben, wie von 0,75-1,25 V, vorzugsweise von 0,9-1,1 V, wie von 0,95-1,05 V, oder von 0,25-0,75 V, vorzugsweise von 0,4-0,6 V, wie 0,5 V.

6. Voltaisches System nach mindestens einem der vorhergehenden Ansprüche, wobei, wenn das voltaische System mehr als eine Schaltung (50) eines intelligenten Zellenstromwandlers (IC3) umfasst, es mindestens ein Modul (52) eines voltaischen Multiplikationsstromwandlers (VMC2) pro voltaischer Einheit umfasst, wobei jedes Modul mindestens zwei IC3-Schaltungen in Reihe umfasst.

7. Voltaisches System nach mindestens einem der vorhergehenden Ansprüche zur Bereitstellung (a) einer variablen Spannung und eines konstanten Stroms mit mindestens zwei voltaischen Einheiten in Reihe oder zur Bereitstellung (b) eines variablen Stroms und einer konstanten Spannung mit mindestens zwei voltaischen Einheiten parallel, oder Kombinationen davon.

8. Voltaisches System nach mindestens einem der Ansprüche 3-7, weiter umfassend eine Steuerung zur Optimierung der Leistungsabgabe durch Schalten von Verbindungen zwischen Spannungsaddierern und voltaischen Einheiten und durch Steuern der Stromversorgung, wobei die Steuerung so ausgelegt ist, dass sie die eine oder die mehreren voltaischen Einheiten abtastet, vorzugsweise mit einer vorbestimmten ersten Frequenz, besonders bevorzugt mit einer ersten Frequenz von 100 bis 100.000 Hz, wie 500 bis 50.000 Hz, vorzugsweise von 1 bis 3 kHz, und/oder
wobei das Steuergerät die eine oder mehreren voltaischen Einheiten mit einer der einen oder mehreren Ladungsabsaugvorrichtungen verbindet, vorzugsweise mit einer vorbestimmten zweiten Frequenz, vorzugsweise mit einer modulierten zweiten Frequenz, vorzugsweise einer sinusförmigen Frequenz von mehr als 25 kHz, und/oder wobei die Steuerung einen Maximum Power Point Tracker (MPPT) umfasst, und/oder
wobei die Steuerung eine Schaltvorrichtung umfasst, und/oder wobei die Steuerung einen Optimierer umfasst.

9. Voltaisches System nach mindestens einem der vorhergehenden Ansprüche, wobei die eine oder die mehreren voltaischen Einheiten ausgewählt sind aus Einzelkontakt- und Mehrfachkontakt-Halbleiter-PV-Einheiten, wie Si-Einheiten, III-IV-Einheiten, Dünnschicht-Solareinheiten, wie CdTe, CuInGaSe, GaAs, organischen Einheiten, Polymereinheiten, Farbstoff-Solareinheiten, Rückkontaktsystemen und Kombinationen davon, und/oder
wobei eine Kapazität einer photovoltaischen Einheit 0-50% kleiner ist als eine Kapazität eines der einen oder mehreren Spannungsaddierer, wobei vorzugsweise der eine oder die mehreren elektrischen Akkumulatoren eine Kapazität von mehr als dem 10-fachen der Kapazität des einen oder der mehreren Spannungsaddierer haben, vorzugsweise von mehr als dem 100-fachen, mehr bevorzugt von mehr als dem 500-fachen, noch mehr bevorzugt von mehr als dem 1000-fachen, und/oder wobei der eine oder die mehreren elektrischen Akkumulatoren in einem Betriebsspannungsbereich von 1-10 V arbeiten.

10. Produkt, ausgewählt aus einem gebäudeintegrierten Photovoltaik-Element (BIPV), einem gebäudeangewandten Photovoltaik-Element (BAPV), einem netzunabhängigen System, einer Solarfarm, einem Voltaik-Element, einem elektrischen Akkumulator, einem Chip, einem Mobiltelefon, einem Gerät, einem Dachziegel, einem Gerät, einem Spiel, einem Warenzeichen, einem Markennamen, einem Zeitgeber, einer Fernbedienung, einem Bild, einem Logo, einer Grafik, einem eigenständigen System und Kombinationen davon, das ein Voltaik-System nach einem der Ansprüche 1-9 umfasst.

11. Produkt nach Anspruch 10, wobei das Produkt geeignet ist, elektrisch in Reihe und/oder parallel verwendet zu werden, wie z.B. ein Dachziegel, eine PV-Einheit und in einem Gitter, und/oder wobei das Produkt eine zufällige Größe hat, und/oder wobei das Produkt eine regelmäßig geformte Größe hat, wie z.B. rechteckig, kreisförmig, multigonal, wie z.B. sechseckig und achteckig, und/oder wobei das Produkt gekrümmt ist.

12. Gebäude mit einem oder mehreren voltaischen Systemen nach einem der Ansprüche 1-9 oder einem oder mehreren Produkten nach Anspruch 11.

## Revendications

1. Système voltaïque (10) pour optimiser le rendement en termes d'énergie électrique, le système voltaïque comprenant
au moins deux unités voltaïques (VU1, VL12), les unités voltaïques étant couplées électriquement l'une à l'autre, chaque unité voltaïque étant capable de fonctionner à une première tension et à un ou plusieurs courant(s),
au moins un circuit convertisseur de courant de cellule intelligente (IC3) (50) pour multiplier la tension des au moins deux unités voltaïques par un premier facteur et diviser le(s) courant(s) des au moins deux unités voltaïques par le premier facteur, et
un ou plusieurs éléments parmi (a) un émetteur d'énergie sans fil (WiPoT) (60) pour transmettre sans fil l'énergie produite par le circuit IC3 et (b) un accumulateur électrique (A3) pour stocker la charge provenant de l'énergie produite par le circuit IC3 (50),
les circuits d'au moins un convertisseur de courant de cellule intelligente IC3 (50) comprenant
(i) deux ou plusieurs (n) additionneurs de tension (V1, V2) et un ou plusieurs additionneurs de courant (C3), la sortie des deux ou plusieurs additionneurs de tension étant connectée à l'entrée du ou des additionneurs de courant
(ii) deux ou plusieurs dispositifs de siphonage de charge (72) par additionneur de tension, de préférence 2-100 dispositifs de siphonage par additionneur de tension, tels que 4-50 dispositifs de siphonage par additionneur de tension, dans lesquels les deux ou plusieurs dispositifs de siphonage de charge sont électriquement connectés en série l'un à l'autre, dans lesquels les deux ou plusieurs dispositifs de siphonage de charge sont adaptés pour être en connexion électrique avec un ou plusieurs additionneurs de tension, et dans lesquels les deux ou plusieurs dispositifs de siphonage de charge comprennent un ou plusieurs condensateurs,
(iii) un ou plusieurs interrupteurs pour connecter ou déconnecter électriquement les composants du système voltaïque, les composants étant choisis parmi les deux unités voltaïques au moins, le circuit IC3 au moins, le WiPOT, l'accumulateur électrique (A3), les deux additionneurs de tension ou plus, et les deux dispositifs de siphonage de charge ou plus, et
(iv) un comparateur (U4) pour comparer la tension de sortie des unités voltaïques avec une valeur seuil et éventuellement commander la récolte d'énergie,
l'émetteur d'énergie sans fil (60) comprenant
un enroulement primaire (Tr1), un enroulement secondaire (Tr2) et un générateur ou oscillateur (U6),
dans lequel l'enroulement primaire est conçu pour être couplé électriquement à un ou plusieurs circuits IC3 via le générateur ou l'oscillateur (U6), et
dans lequel l'enroulement secondaire est conçu pour être couplé électriquement à un ou plusieurs dispositifs de charge et au réseau électrique.

2. Système voltaïque selon la revendication 1, adapté pour être fixé à une surface ou à une partie de celle-ci, dans lequel l'unité voltaïque est une unité photovoltaïque, chaque unité comprenant indépendamment de 1 à 10 cellules photovoltaïques, de préférence de 1 à 5 cellules photovoltaïques, par exemple de 2 à 4 cellules photovoltaïques.

3. Système voltaïque selon au moins une des revendications précédentes, dans lequel le circuit (IC3) comprend 2m dispositifs de siphon de charge, où m est choisi parmi {2;10}, de préférence parmi {3;9}, par exemple {4;8}.

4. Système voltaïque selon au moins l'une des revendications précédentes, dans lequel, lorsque le système voltaïque comprend un ou plusieurs des éléments suivants (i) un WiPOT, l'émetteur WiPoT comprend en outre au moins un deuxième accumulateur électrique (41), tel qu'un accumulateur Li-ion et un condensateur.

5. Système voltaïque selon au moins une des revendications précédentes, dans lequel le circuit (IC3) comprend un ou plusieurs transistors, de préférence un ou plusieurs FET, dans lequel le ou les transistors ont une plage de tension de fonctionnement limitée, par exemple de 0,75 à 1,25 V, de préférence de 0,9 à 1,1 V, par exemple de 0,95 à 1,05 V, ou de 0,25 à 0,75 V, de préférence de 0,4 à 0,6 V, par exemple 0,5 V.

6. Système voltaïque selon au moins l'une des revendications précédentes, dans lequel, lorsque le système voltaïque comporte plus d'un circuit (50) de convertisseur de courant de cellule intelligente (IC3), il comporte au moins un module (52) de convertisseur de courant multiplicateur voltaïque (VMC2) par unité voltaïque, chaque module comportant au moins deux circuits IC3 en série.

7. Système voltaïque selon l'une au moins des revendications précédentes, pour fournir (a) une tension variable et un courant constant avec au moins deux unités voltaïques en série ou pour fournir (b) un courant variable et une tension constante avec au moins deux unités voltaïques en parallèle, ou des combinaisons de ceux-ci.

8. Système voltaïque selon au moins l'une des revendications 3-7, comprenant en outre un contrôleur pour optimiser la puissance de sortie en commutant les connexions entre les additionneurs de tension et les unités voltaïques, et en contrôlant l'alimentation électrique, dans lequel le contrôleur est adapté pour échantillonner l'une ou plusieurs unités voltaïques, de préférence à une première fréquence prédéterminée, plus préférentiellement à une première fréquence de 100 à 100 000 Hz, telle que 500 à 50 000 Hz, de préférence de 1 à 3 kHz, et/ou
dans lequel le contrôleur connecte la ou les unités voltaïques à l'un des dispositifs de siphonage de charge, de préférence à une seconde fréquence prédéterminée, de préférence à une seconde fréquence modulée, de préférence à une fréquence sinusoïdale de plus de 25 kHz, et/ou
dans lequel le contrôleur comprend un dispositif de suivi du point de puissance maximale (MPPT), et/ou
dans lequel le contrôleur comprend un dispositif de commutation, et/ou dans lequel le contrôleur comprend un optimiseur.

9. Système voltaïque selon au moins une des revendications précédentes, dans lequel une ou plusieurs unités voltaïques sont choisies parmi les unités PV semi-conductrices à jonction unique et à jonction multiple, telles que les unités Si, les unités III-IV, les unités solaires à couche mince, telles que CdTe, CuInGaSe, GaAs, les unités organiques, les unités polymères, les unités solaires à colorant, les systèmes à contact arrière, et leurs combinaisons, et/ou
dans lequel la capacité d'une unité voltaïque est inférieure de 0 à 50 % à la capacité d'un ou de plusieurs additionneurs de tension, dans lequel, de préférence, le ou les accumulateurs électriques ont une capacité supérieure à 10 fois la capacité du ou des additionneurs de tension, de préférence supérieure à 100 fois, de préférence supérieure à 500 fois, de préférence encore supérieure à 1000 fois, et/ou dans lequel le ou les accumulateurs électriques fonctionnent dans une plage de tension de fonctionnement de 1 à 10 V.

10. Produit, choisi parmi un élément photo voltaïque intégré au bâtiment (BIPV), un élément photo voltaïque appliqué au bâtiment (BAPV), un système hors réseau, une ferme solaire, un élément voltaïque, un accumulateur électrique, une puce, un téléphone mobile, un dispositif, une tuile, un appareil, un jeu, une marque, un nom de marque, une minuterie, une télécommande, une image, un logo, des graphiques, un système autonome, et des combinaisons de ceux-ci, comprenant un système voltaïque conforme à l'une des revendications 1-9.

11. Produit selon la revendication 10, dans lequel le produit est adapté pour être utilisé électriquement en série et/ou en parallèle, comme une tuile, une unité PV, et dans une grille, et/ou dans lequel le produit a une taille aléatoire, et/ou dans lequel le produit a une taille de forme régulière, comme rectangulaire, circulaire, multigonale, comme hexagonale, et octogonale, et/ou dans lequel le produit est courbé.

12. Bâtiment comprenant un ou plusieurs systèmes voltaïques selon l'une des revendications 1-9 ou un ou plusieurs produits selon la revendication 11.
